# EUROPÄISCHE PATENTSCHRIFT

(11) **EP 2 880 696 B1**
(45) Veröffentlichungstag und Bekanntmachung des Hinweises auf die Patenterteilung: **04.11.2015**
(21) Anmeldenummer: 13731702.0
(22) Anmeldetag: 31.05.2013
(51) Int. Cl.: H01L 41/06

(54) **AKTUATORVORRICHTUNG**
ACTUATOR DEVICE
DISPOSITIF D'ACTIONNEMENT

(30) Priorität: 01.08.2012 DE 102012107014
(43) Veröffentlichungstag der Anmeldung: 10.06.2015
(73) Patentinhaber: Eto Magnetic GmbH, 78333 Stockach (DE)
(72) Erfinder: LAUFENBERG, Markus, 78333 Stockach (DE); SCHIEPP, Thomas, 78606 Seitingen-Oberflacht (DE)
(74) Vertreter: Behrmann, Niels
(86) Internationale Anmeldenummer: PCT/EP2013/061307
(87) Internationale Veröffentlichungsnummer: WO 2014/019738

(56) Entgegenhaltungen:
- CN-C- 100 388 611
- CN-Y- 201 234 215
- DE-A1-102004 060 532
- DE-A1-102005 038 891
- DE-B3-102011 052 528

## Beschreibung

Die vorliegende Erfindung betrifft eine Aktuatorvorrichtung nach dem Oberbegriff des Patentanspruchs 1. Eine derartige Vorrichtung ist aus der DE 10 2005 038 891 A1 sowie der nicht vorveröffentlichten DE 10 2011 052 528 bekannt.

Aus diesem Stand der Technik (wie auch der zugrundeliegenden, als bekannt vorausgesetzten allgemeinen Technologie) ist es bekannt, magnetisch wirksame Formgedächtnislegierungsmaterialien (MSM-Materialien = Magnetic Shape Memory, hier gleichbedeutend mit FGL-Formgedächtnislegierung) für die Aktorik zu benutzen. So wird etwa typischerweise zu dem Zweck ein MSM-(FGL-)Kristallkörper (als Repräsentant für eine Vielzahl von möglichen MSMbasierten Materialien), etwa hergestellt auf der Basis einer NiMnGa-Legierung, mit einem durch eine bestromte Spule erzeugten Magnetfeld beaufschlagt. Als Reaktion auf eine solche magnetische Feldbeaufschlagung führt der MSM-Kristallkörper eine Expansionsbewegung durch, in einer Richtung senkrecht zur Durchflutungsrichtung mit dem elektromagnetisch erzeugten Feld. Diese Expansionsbewegung kann dann an einem angetriebenen Ende einen geeignet mit diesem Ende zusammenwirkenden Stellpartner antreiben.

Damit bieten derartige, magnetisch wirksame Formgedächtnislegierungsmaterialien und damit in der beschriebenen prinzipiellen Art realisierte Aktuatoren (Aktuatorvorrichtungen) eine Möglichkeit, gängige magnetbasierte Aktuatorprinzipien (wie etwa elektromagnetische Aktuatoren) zu ersetzen bzw. zu ergänzen. Vorteilhaft ist bei dem verwendeten magnetischen Formgedächtnislegierungsmaterial neben mechanisch-konstruktiver Einfachheit in der Realisierung (es bewegt sich kein Anker als Ganzes, es findet lediglich eine Expansion der Expansionseinheit statt) vor allem eine potentiell schnelle Reaktionszeit der Expansion auf das Anlegen des Magnetfeldes (in der notwendigen Stärke).

Allerdings haben als bekannt vorausgesetzte, MSM-basierte Aktuatorvorrichtungen auch (prinzip- bzw. konstruktionsbedingte) Nachteile gegenüber anderen Aktuatorprinzipien, wodurch in der Praxis eine wirklich universelle Verwendbarkeit bislang eingeschränkt war. So ist etwa ein nutzbarer Hub der Expansionsbewegung (d.h. ein Streckenmaß einer von dem MSM-Kristall durchgeführten Streckbewegung) typischerweise beschränkt auf ca. 3% bis 6% einer entsprechenden axialen Erstreckung des Kristalls, so dass gerade großhubige Bewegungen nur schwierig mittels FGL-/MSM-Aktuatoren realisierbar sind.

Darüber hinaus weisen bekannte MSM-(FGL-) Aktuatoren die Eigenschaft auf, dass als Reaktion auf ein angelegtes Magnetfeld (einer notwendigen MindestFeldstärke) die beabsichtigte Expansionsbewegung stattfindet. Nach einem Abfall des Magnetfeldes (unter die Mindestschwelle) findet dann jedoch nicht automatisch eine Kompression zurück in den ursprünglichen komprimierten Zustand (die Ausgangslage) statt. Vielmehr verbleibt der Kristall auf dem FGL-Material auch bei dem Abfall unter einer Expansionsschwelle bzw. bei dem völligen Deaktivieren des Magnetfeldes in der expandierten Position. Bei aus dem Stand der Technik bekannten Vorrichtungen, wie etwa der zur Gattung zitierten DE 10 2005 038 891 A1, wird daher das Zurückstellen (d.h. das Zurückführen der Expansion in die nicht-expandierte Ausgangslage) mit Rückstellmitteln realisiert, welche hier als mechanische Feder ausgebildet sind. Eine derartige Feder übt ihre Federkraft entgegen der Expansionsrichtung aus. Wenn damit die Federkraft einer solchen bekannten Rückstellfeder, bezogen auf eine (unbelastete) Expansionskraft des FGL-Kristalls, so eingerichtet ist, dass bei der Magnetfeldbeaufschlagung das FGL-Material die Gegenkraft (Rückstellkraft) der Feder übersteigt, findet die beabsichtigte Expansionsbewegung statt. Fällt dann nach Ende der Bestromung das Magnetfeld ab (unter die notwendige Mindestfeldstärke), führt die auf das MSM-Kristall wirkende Federkraft (Rückstellkraft) dann zu der Kontraktion zurück in die Ausgangslage.

Durch eine geeignete Kombination des die Expansionseinheit prägenden FGL- (MSM-) Kristalls als FGL-Material im Zusammenwirken mit der geeignet dimensionierten Rückstellfeder wird somit ein gewünschtes Stell- und Rückstellverhalten erreicht, so dass zahlreiche Stellaufgaben mit einer solchen Technologie durchgeführt werden können.

Allerdings besitzt die Nutzung einer Feder (etwa einer Spiralfeder, wie in der DE 10 2005 038 891 A1 offenbart) den Nachteil einer im Kraft-Weg-Diagramm typischerweise linear ansteigenden Kennlinie, also im zunehmend expandierten Zustand der Expansionseinheit (also bei steigendem Expansionshub) steigt die auf die Expansionseinheit wirkende Rückstell-Federkraft. Gerade im Hinblick auf eine über den gesamten Stellhub (Expansionshub) wünschenswerte konstante Stellkraft einer gattungsgemäßen Aktuatorvorrichtung ist diese Eigenschaft nachteilig, denn sie führt regelmäßig dazu, dass kurz vor Ende des wirksamen Hubmaximums die Stellkraft deutlich abfällt und damit manche Stellaufgaben nicht mehr zuverlässig realisierbar sind. Auch ist damit die durch eine solche Vorrichtung (d.h. Kombination aus FGL-basierter Expansionseinheit mit Rückstellfeder) realisierte Arbeit (als Differenz zwischen MSM-Stellkraft und Feder-Rückstellkraft über den wirksamen Hubbereich) entsprechend begrenzt.

Die DE 10 2011 052 528 der Anmelderin stellt bereits diesen prinzipbedingten Nachteil der gattungsbildenden Technologie fest und löst die sich daraus ergebende Aufgabe einer Vergleichmäßigung der (resultierenden) Stellkraft über den gesamten Expansionshub dadurch, dass als Rückstellmittel eine Federkombination bzw. Federausgestaltung herangezogen wird, deren Rückstell-Kraftverhalten über den Expansionsverlauf nicht linear ansteigend ist, sondern zumindest abschnittsweise abfällt bzw. einen flachen Verlauf zeigt. Im Ergebnis erhöht sich damit auch in expandierten Hubabschnitten die an einen nachgeschalteten Stellpartner wirkende Stellkraft.

Allerdings ist auch diese Vorgehensweise mechanisch aufwändig, verlangt nach sorgfältiger Einrichtung der hier vorzusehenden Federeinheiten als Rückstellmittel und bietet insoweit das Potential für weitere Verbesserungen.

Aufgabe der vorliegenden Erfindung ist es daher, eine gattungsgemäße Aktuatorvorrichtung im Hinblick auf ihr (Stell-) Kraftverhalten entlang des gesamten Bewegungshubes zu verbessern, dabei eine zuverlässige Rückstellung durch die Rückstellmittel zu gewährleisten. Insbesondere ist im Hinblick auf die erfindungsgemäßen Rückstellmittel eine Alternative zu den als bekannt vorausgesetzten Rückstellfedern zu schaffen.

Die Aufgabe wird durch die Aktuatorvorrichtung mit den Merkmalen des Hauptanspruchs gelöst. Vorteilhafte Weiterbildungen der Erfindung sind in den Unteransprüchen beschrieben.

In erfindungsgemäß vorteilhafter Weise sind anstelle der Federn (in bevorzugter Weiterbildung der Erfindung enthalten die Rückstellmittel keine Feder, bzw. es wirkt keine Feder mit einer Rückstellkraft auf die Expansionseinheit) Permanentmagnetmittel vorgesehen, die so an einen Abschnitt der Expansionseinheit angreifen oder an diesem ansitzen, dass eine permanentmagnetisch erzeugte Rückstellkraft auf die Expansionseinheit wirkt, welche die Expansionseinheit von einem expandierten Zustand zurück in die komprimierte Ausgangslage verbringen kann. Dabei sind die Permanentmagnetmittel so vorgesehen (und entweder unmittelbar an einem (End-) Abschnitt der Expansionseinheit vorgesehen und/oder an einem nicht beweglichen Statorabschnitt der Aktuatorvorrichtung angebracht), dass in Abhängigkeit von einer aktuellen Expansion (einem aktuellen Expansionshub) diese permanentmagnetische, auf die Expansionseinheit entgegen der Expansionsrichtung wirkende Rückstellkraft variiert.

In besonders bevorzugter Form sind dabei die Permanentmagnetmittel so eingerichtet bzw. vorgesehen und ausgebildet, dass bei zunehmender Expansion (d.h. steigendem Expansionshub in der Expansionsrichtung) die permanentmagnetisch erzeugte Rückstellkraft absinkt, mit dem Ergebnis, dass entgegen einer bekannten und als gattungsbildend vorausgesetzten Federkennlinie mit zunehmender Expansion die resultierende Kraft der Aktuatorvorrichtung (d.h. aus der Expansion des FGL-Materials wirkende Expansionskraft abzüglich Rückstellkraft) nicht abfällt, vielmehr konstant bleiben oder sogar ansteigen kann. Dies ermöglicht dann erfindungsgemäß vorteilhaft, dass ein annähernd konstanter (ggf. sogar ansteigender) resultierender Krafteintrag in den mit dem erfindungsgemäßen Aktuator zu stellenden Stellpartner erfolgen kann, so dass gegenüber einer gattungsgemäßen federbasierten Lösung völlig neue Möglichkeiten eröffnet sind.

Dabei ist es im Rahmen bevorzugter Weiterbildungen der Erfindung besonders bevorzugt und günstig, das erfindungsgemäß zur Expansion benutzte FGL- (MSM-) Material so einzurichten und vorzusehen, dass der durch die Bestromung der Spulenvorrichtung erzeugte elektromagnetische Magnetfluss dieses Formgedächtnislegierungsmaterial quer durchfließt, d.h. in einer Richtung senkrecht zur Expansions- bzw. Bewegungsrichtung. Dies geschieht erfindungsgemäß vorteilhaft dadurch, dass seitlich benachbart dem FGL-Material (FGL-Kristall) geeignete Flussleitmittel, etwa in Form geeignet flussleitender Abschnitte, ausgebildet sind, welche gleichermaßen als Stator der Aktuatorvorrichtung fungieren. Besonders günstig etwa im Rahmen einer radialsymmetrischen Vorrichtung ist es, einen solchen Stator dann mantelseitig eines zentralen, weiter bevorzugt in der Expansionsrichtung langgestreckten FGL-(MSM-) Kristalls auszubilden.

Wird dann, gemäß einer weiteren bevorzugten Ausführungsform, endseitig eines derartigen langgestreckten MSM-Kristalls (mit zwischengeschaltetem magnetfreiem Abschnitt) ein Permanentmagnetelement (Permanentmagnetkörper) vorgesehen, kann dieser Stator in seinem dem Permanentmagnetkörper benachbarten Abschnitt als Flussleiter für das Permanentmagnetfeld wirken, insoweit (unter Ausbildung eines Luftspalts) den permanentmagnetischen Flusskreis schließen. Wird dann bei Bestromung der Spulenvorrichtung der elektromagnetisch erzeugte Fluss durch den FGL-Kristall geleitet, erfolgt die Expansion der Expansionsvorrichtung, mithin auch das Bewegen des endseitig ansitzenden Permanentmagneten entlang der Hubrichtung aus der Ausgangsposition, mit der Wirkung, dass der Luftspalt zum Stator wächst. Ergebnis ist eine Abschwächung der permanentmagnetischen Anziehungskraft (damit entsprechend der Rückstellkraft auf die Expansionseinheit) und das Erreichen eines wesentlichen Ziels der vorliegenden Erfindung, nämlich der Wirkung, dass in dieser expandierten Position zwar nach wie vor eine permanentmagnetische Rückstellkraft entgegen der Expansionsrichtung und zur Kompression bei deaktivierter Bestromung wirkt, diese permanentmagnetische Rückstellkraft in der ausgefahrenen Position jedoch gegenüber der ursprünglichen, komprimierten Position deutlich kleiner ist. Entsprechend vergrößert ist die resultierende Stellkraft der Aktuatorvorrichtung in Richtung auf den expandierten Zustand.

In weiteren Ausgestaltungen der Erfindung gemäß bevorzugter Weiterbildungen ist es dann bevorzugt, insbesondere den permanentmagnetischen Flusskreis bzw. dessen Veränderung (genauer: Veränderung eines Luftspalts) durch die Hubbewegung auszugestalten. Weitere bevorzugte Ausführungsbeispiele sehen hier etwa günstig vor, den endseitig an der Expansionseinheit vorgesehenen Permanentmagnetmitteln becher-, bogen- oder jochartig ausgeformte Flussleitmittel zuzuordnen, ergänzend oder alternativ selbst die Permanentmagnetmittel in dieser Art flussleitend (rückschlusstauglich) auszugestalten und/oder geeignet ausgebildete Permanentmagnetmittel in eine solche Flussleitstruktur flussleitend einzubetten.

Dabei ist es einerseits bevorzugt, etwa bei der Nutzung von zylindrisch ausgestalteten Permanentmagnetkörpern, diese axial zu magnetisieren (wobei als "axial" im Rahmen der vorliegenden Erfindung die Hub- bzw. Expansionsrichtung verstanden werden soll), ergänzend oder alternativ, etwa bei der Nutzung geeignet scheibenförmiger Permanentmagnetkörper, könnte sich eine radiale Magnetisierung als sinnvoll und vorteilhaft erweisen.

Insbesondere bei einer Variante im Rahmen der vorliegenden Erfindung, bei welcher sowohl ankerseitig (d.h. verbunden mit der Expansionseinheit und durch diese bewegt), als auch statorseitig (d.h. durch die Expansion unbewegt) jeweils Permanentmagnetmittel vorgesehen und zum Zusammenwirken miteinander ausgestaltet sind, lassen sich höchst wirksame Effekte und Ausgestaltungen des resultierenden Rückstell-Kraftverlaufs (und damit des Gesamt-Kraftverlaufs) erreichen: Indem nämlich etwa Permanentmagnetpole gleicher Polarität sowohl stator- als auch ankerseitig aufeinander gerichtet sind, wird ein dadurch erzielter Abstoßungseffekt (im Zusammenwirken zwischen den Permanentmagneteinheiten) benutzt werden können, um entlang der Hubrichtung (Expansionsrichtung) ein geeignetes Kraftverhalten bzw. eine Beeinflussung der Rückstellkraft entlang des Hubes zu erreichen. Auch lassen sich im Rahmen bevorzugter Weiterbildungen der Erfindung einzelne Permanentmagnetkörper ausbilden aus einer Mehrzahl von geeignet beschichteten, ggf. auch gegenpolig zueinander ausgebildeten und befestigten Permanentmagnetkörpern als erfindungsgemäße Permanentmagnetmittel. Wiederum ergänzend oder alternativ ist es weiterbildungsgemäß vorgesehen, stator- oder ankerseitig geeignete Koni auszubilden, welche in ihrem Flussleitverhalten (bezogen auf einen zwischenliegenden Luftspalt) geeignete permanentmagnetische Flüsse beeinflussen und so zusätzlich die Möglichkeit bieten, einen gewünschten Kraftverlauf einzustellen bzw. konstruktiv auszugestalten.

Während typische und bevorzugte Anwendungsgebiete der vorliegenden Technologie etwa im Bereich der Kraftfahrzeug- bzw. Antriebstechnologie liegen (etwa zur Betätigung von Ventilen, zum Einstellen von Motoraggregaten oder dergleichen), ist die vorliegende Erfindung nicht auf derartige typische Anwendungsgebiete beschränkt. Vielmehr eignet sich die vorliegende Erfindung für jegliche Anwendungsgebiete, bei welchen die Vorteile eines geeignet gestaltbaren, potentiell nicht durch eine mechanische Feder im Hub-Endbereich begrenzten bzw. absinkenden Kraftverlaufs benutzt werden können, um eine jeweilige Stellaufgabe zuverlässig, betriebssicher und mit einfacher Fertigbarkeit zu realisieren.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in
- Fig. 1, 2:: eine erste Ausführungsform der vorliegenden Erfindung in Ausgangslage (Fig. 1) bzw. expandiertem Zustand (Fig. 2);
- Fig. 3, 4:: eine zweite Ausführungsform der vorliegenden Erfindung mit einer Variante der Ausgestaltung der Permanentmagnetmittel gegenüber der ersten Ausführungsform wiederum in Ausgangslage (Fig. 3) bzw. expandiert (Fig. 4);
- Fig. 5-9:: weitere Varianten des vorliegenden erfindungsgemäßen Prinzips als weitere Ausführungsformen mit verschiedenen Ausgestaltungen der Permanentmagnetmittel an der Expansionseinheit (Fig. 5, Fig. 6) bzw. statorseitig (Fig. 7 - 9);
- Fig. 10-13:: weitere Ausführungsformen der vorliegenden Erfindung mit sowohl statorseitigen Permanentmagnetkörpern, als auch an der Expansionseinheit vorgesehenen Permanentmagnetkörpern, und
- Fig. 14,15:: eine weitere Ausführungsform der Erfindung als Weiterbildung der ersten Ausführungsform der Fig. 1, 2 mit zusätzlich der Expansionseinheit rückstellend zugeordneten mechanischen Federn, welche zur permanentmagnetischen Rückstellkraft gleichgerichtete Rückstellkräfte auf die Expansionseinheit ausüben.

Bei den nachfolgend beschriebenen Ausführungsbeispielen werden gleiche bzw. äquivalente Funktionskomponenten mit gleichen Bezugszeichen bezeichnet.

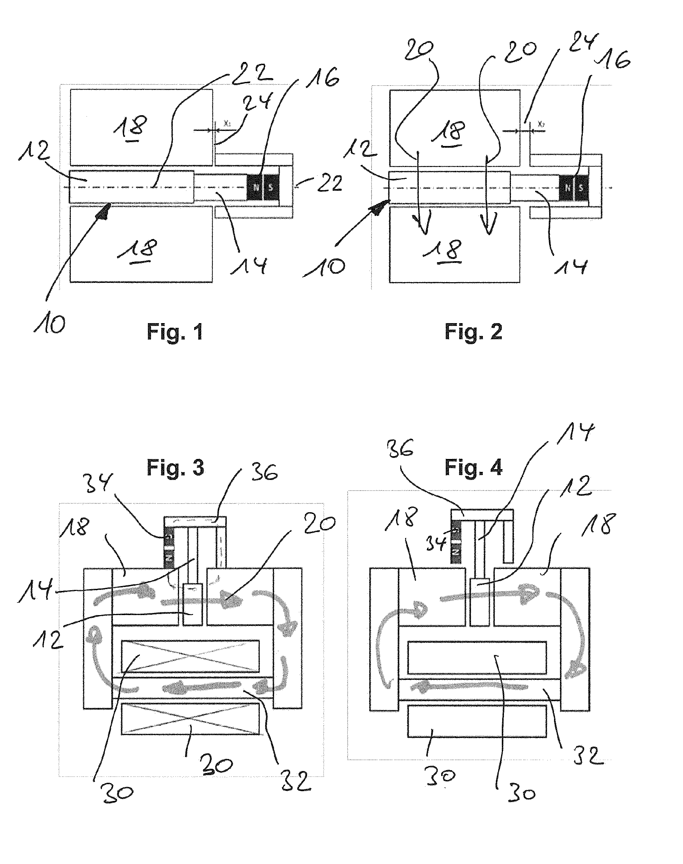

Die Fig. 1 zeigt als fragmentative Darstellung (und ohne Darstellung einer Spulenvorrichtung zur Erzeugung des Elektromagnetfeldes) eine erste Ausführungsform der vorliegenden Erfindung.

Eine Expansionseinheit 10 bestehend aus einem langgestreckten Formgedächtnislegierungs-Kristall 12, einem daran anschließenden magnetisch nichtleitenden Abschnitt 14 sowie einem axial magnetisierten Permanentmagnetkörper 16 ist in der Art eines Stößels innerhalb eines flussleitenden Stators 18 geführt. Dieser flussleitende Stator leitet einen Elektromagnetfluss der nicht gezeigten Spulenmittel in einer Querrichtung entlang einer Pfeilrichtung 20 durch den MSM-Kristall 12, zum Bewirken einer Expansionsbewegung in axialer Richtung, entsprechend der gezeigten Achse 22.

Wie die Fig. 1, 2 zusätzlich zeigen, ist dem Permanentmagnetkörper 16 ein becherförmiges Flussleitelement 24 zugeordnet, welches unter Ausbildung eines Luftspalts 24 (Abstand x1 in der Ausgangslage der Fig. 1) einen permanentmagnetischen Flusskreis über den Stator 18 schließt.

Gegenüber dem unbestromten Spulenzustand der Fig. 1 verdeutlicht die Fig. 2 den Bestromungszustand (Flusspfeile 20 durch den MSM-Kristall 12). Dieser Kristall expandiert entlang der Expansionsrichtung (in der Figurenebene nach rechts), mit dem Ergebnis, dass der Luftspalt 24 des permanentmagnetischen Flusskreises sich auf den Abstand x2 erweitert. Entsprechend schwächer ist die permanentmagnetische Anziehungskraft des Flussleitkörpers 24 in Richtung auf den Stator 18, soweit entsprechend einer schwächeren, entgegen der Expansionsrichtung wirkenden Rückstellkraft. Gleichwohl ist die Vorrichtung so konfiguriert, dass auch noch im expandierten Zustand der Fig. 2 bei deaktivierter Spulenvorrichtung der Permanentmagnetfluss groß genug ist, um analog dem Verhalten einer Rückstellfeder die rückstellende Kraft auf das FGL-Material des Kristalls 12 auszuüben und entsprechend die Expansionseinheit 10 zurück in den Ausgangszustand (Ausgangslage) der Fig. 1 zu verbringen.

Die Fig. 3 und 4 zeigen eine zweite Ausführungsform der vorliegenden Erfindung, in etwas detaillierterer Ausgestaltung und mit zusätzlich gezeigter Spuleneinheit 30, welche um einen flussleitenden Abschnitt 32 vorgesehen ist und in der gezeigten Weise den quer verlaufenden Elektromagnetfluss 20 in die Flussleitelemente (Stator) 18 einbringt. Beim Ausführungsbeispiel der Fig. 3, 4 ist, in Abweichung vom ersten Ausführungsbeispiel, das dem Permanentmagnetkörper (nach wie vor axial magnetisiert) 34 zugeordnete Flussleitelement 36 so ausgebildet, dass der Permanentmagnetkörper 34 teilweise in dessen Mantelfläche aufgenommen ist.

Auch zeigen die schematisch in die Darstellung der Fig. 3, 4 eingezeichneten Pfeile, dass der Flussleitabschnitt 32 den permanentmagnetischen Flusskreis schließt.

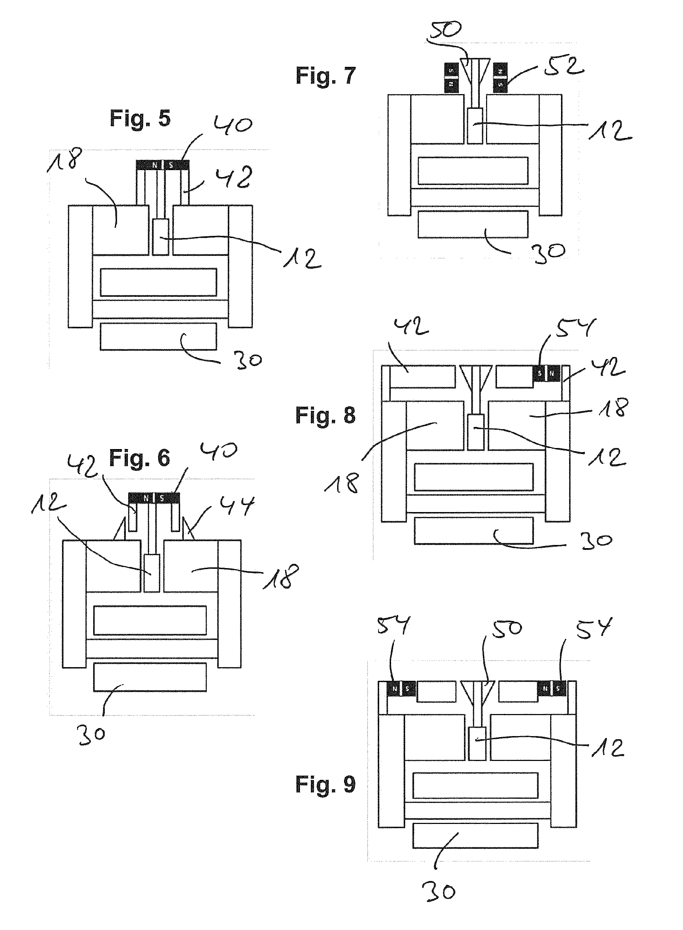

Die Fig. 5 und 6 zeigen weitere Varianten eines ankerseitigen (d.h. an der Expansionseinheit selbst vorgesehen und mit dieser beweglichen) Permanentmagneteinheit, in den Fig. 5, 6 in Form eines scheibenförmigen bzw. stabförmigen Permanentmagnetkörpers 40, welcher stirnseitig einer zugeordneten Flussleiteinheit 42 ausgebildet ist. Als zusätzliche Variante enthält der Stator 18 beim Ausführungsbeispiel der Fig. 6 einen Konusabschnitt 44, welcher durch seine Ausgestaltung den Flussübergang im Luftspalt zum Anker hubabhängig bestimmt.

Dagegen zeigen die Ausführungsbeispiele der Fig. 7 bis 9 eine Expansionseinheit, welche zwar endseitig eine (wiederum bevorzugt konusförmig ausgestaltete) Flussleiteinheit 50 aufweist, zum Zusammenwirken mit statorseitigen Permanentmagnetmitteln ausgebildet ist, selbst jedoch an der Expansionseinheit keinen Permanentmagneten vorsieht. Insoweit stellen die Ausführungsbeispiele der Fig. 7 bis 9 mit jeweiligen Varianten von statorseitigen Permanentmagnetkörpern 52 (als axial magnetisierten Permanentmagneten in Fig. 7, oder als Stabmagneten 54 in den Varianten der Fig. 8, 9) Umkehrungen des mit einem statorseitigen Konus versehenen Prinzips der Fig. 6 dar. Wiederum obliegt es einem jeweiligen Anwendungsfall und einer konkreten Konfiguration, die jeweilige Permanentmagnetanordnung, -ausgestaltung und Einbindung in einen Permanentmagnetfluss einem jeweiligen Stellzweck und einer gewünschten Kraftentfaltung geeignet zuzuordnen.

Prinzipiell entspricht das Bewegungs- und Kraftverhalten dem ersten Ausführungsbeispiel der Fig. 1, 2.

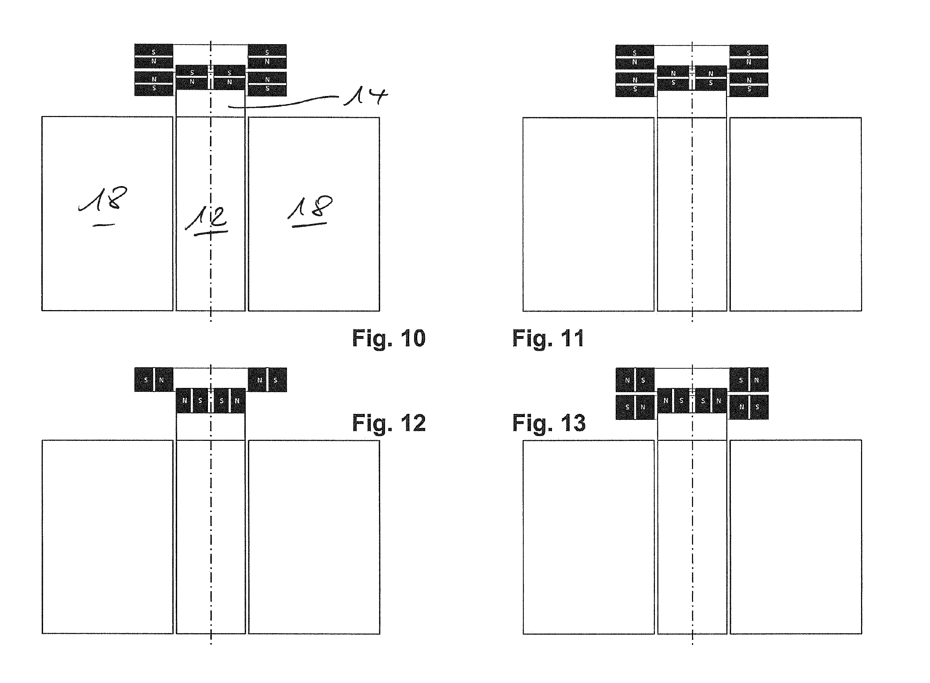

Die Fig. 10 bis 13 zeigen Varianten der Erfindung als weitere Ausführungsbeispiele, bei welchen sowohl an der Expansionseinheit, als auch statorseitig Permanentmagnetanordnungen vorgesehen sind, geeignet in Form von scheiben- bzw. ringförmigen Permanentmagnetkörpern, welche einzeln bzw. gruppiert vorgesehen sind. Entsprechend ihrem Zusammenwirken mit der Expansionseinheit wird dabei ein Anziehungs- bzw. Abstoßungseffekt ausgenutzt, wobei etwa das Ausführungsbeispiel der Fig. 10 verdeutlicht, wie entlang des Bewegungshubes (in der Figur in vertikaler Richtung) zwischen der Expansionseinheit und der umgebenden Statorseite zunächst Anziehungseffekte, dann Abstoßungseffekte bei gleichpolarer Polarität wirken. Auch hier sind lediglich prinzipielle Darstellungsformen offenbart, welche für einen jeweiligen Anwendungsfall beliebig ausgestaltet werden können.

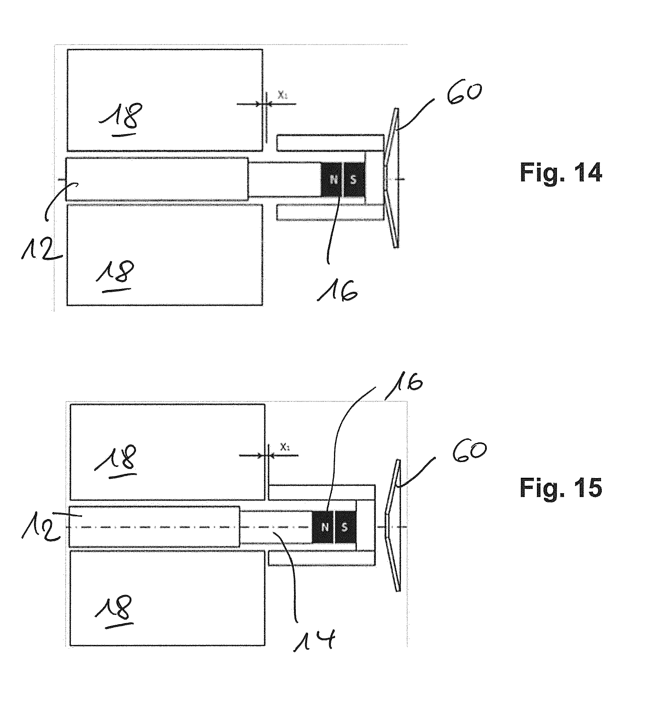

Die Fig. 14 und 15 als weitere Ausführungsform zeigen, wie zu dem Zweck einer zusätzlichen, etwa endseitigen Rückstellkrafterhöhung der Expansionseinheit eine mechanische Feder (hier als Tellerfeder 60 gezeigt) zugeordnet werden können. Die Gegenüberstellung der Fig. 15 (expandierter Zustand und Zugriff auf die Feder) relativ zur Fig. 16 (kontrahierter Zustand ohne mechanischem Federkontakt) verdeutlicht, dass auch hier, expansionswegabhängig, eine zusätzliche Beeinflussung des Kraftverhaltens möglich ist.

Die vorliegende Erfindung ist nicht auf die gezeigten Ausführungsbeispiele beschränkt, vielmehr bieten sich beliebige Kombinationen zur Ausgestaltung eines gewünschten Kraftverhaltens entlang des Hubweges an.

## Patentansprüche

1. Aktuatorvorrichtung mit einer ein magnetisch wirksames Formgedächtnislegierungsmaterial (12) aufweisenden Expansionseinheit (10), die als Reaktion auf eine Bestromung einer Spulenvorrichtung (30) entlang einer Expansionsrichtung aus einer Ausgangslage eine Expansionsbewegung durchführt
und mit Rückstellmitteln zusammenwirkt, die auf die Expansionseinheit (10) eine der Expansionsrichtung entgegengesetzte Rückstellkraft ausüben,
**dadurch gekennzeichnet, dass**
die Rückstellmittel Permanentmagnetmittel aufweisen, die so an einem Abschnitt der Expansionseinheit (10) angreifen oder ansitzen, dass die permanentmagnetisch erzeugte Rückstellkraft sich mit wachsendem Expansionshub in der Expansionsrichtung ändert,
wobei die Permanentmagnetmittel (16, 34, 40, 52, 54) so ausgebildet und/oder eingerichtet sind, dass entlang des Expansionshubes bei unbestromter Spulenvorrichtung (30) eine Kontraktion der Expansionseinheit (10) in die Ausgangslage erfolgen kann.

2. Vorrichtung nach Anspruch 1, **dadurch gekennzeichnet, dass** die Permanentmagnetmittel so ausgebildet und/oder eingerichtet sind, dass die permanentmagnetisch erzeugte Rückstellkraft mit wachsendem Expansionshub zumindest abschnittsweise sinkt oder abnimmt.

3. Vorrichtung nach Anspruch 1 oder 2, **dadurch gekennzeichnet, dass** das langgestreckt entlang der Expansionsrichtung ausgebildete Formgedächtnislegierungsmaterial (12) seitlich und/oder mantelseitig Flussleitmittel (18, 32) zugeordnet aufweist, die eine magnetische Durchflutung (20) des Formgedächtnislegierungsmaterials (12) durch die Bestromung in einer Flussrichtung quer zur Expansionsrichtung bewirken.

4. Vorrichtung nach Anspruch 3, **dadurch gekennzeichnet, dass** die Flussleitmittel so mit den Permanentmagnetmitteln zusammenwirken, dass die Flussleitmittel während der Bestromung und bei der unbestromten Spulenvorrichtung (30) zumindest abschnittsweise von einem Permanentmagnetfluss der Permanentmagnetmittel durchflossen sind.

5. Vorrichtung nach einem der Ansprüche 1 bis 4, **dadurch gekennzeichnet, dass** die langgestreckt ausgebildete Expansionseinheit (10) an einem durch die Expansion bewegten Endabschnitt die Permanentmagnetmittel (16, 34, 40) aufweist.

6. Vorrichtung nach einem der Ansprüche 1 bis 5, **dadurch gekennzeichnet, dass** den Permanentmagnetmitteln Permanentmagnetflussleitmittel (24, 36) zugeordnet sind, die einen Permanentmagnetfluss zu einer dem Formgedächtnislegierungsmaterial (12) zugeordneten stationären Kerneinheit (18) leiten können.

7. Vorrichtung nach Anspruch 6, **dadurch gekennzeichnet, dass** die Permanentmagnetflussleitmittel oder die Permanentmagnetmittel becher-, bogen- oder jochartig geformt sind.

8. Vorrichtung nach einem der Ansprüche 1 bis 7, **dadurch gekennzeichnet, dass** die Permanentmagnetmittel, bezogen auf die Expansionsrichtung, einen axial magnetisierten Permanentmagnetkörper aufweisen.

9. Vorrichtung nach einem der Ansprüche 1 bis 8, **dadurch gekennzeichnet, dass** die Permanentmagnetmittel einen scheibenförmig realisierten und radial magnetisierten Permanentmagnetkörper aufweisen.

10. Vorrichtung nach einem der Ansprüche 1 bis 9, **dadurch gekennzeichnet, dass** ein erster Permanentmagnetkörper der Permanentmagnetmittel bevorzugt endseitig an der Expansionseinheit (10) und zum magnetischen Zusammenwirken mit einem diesem bevorzugt lateral benachbart an einem Statorabschnitt (18) vorgesehenen zweiten Permanentmagnetkörper der Permanentmagnetmittel vorgesehen ist.

11. Vorrichtung nach Anspruch 10, **dadurch gekennzeichnet, dass** der erste und der zweite Permanentmagnetkörper als, bezogen auf die Expansionsrichtung, radial magnetisierter Permanentmagnetkörper mit aufeinander gerichteten gleichen Polen realisiert ist.

12. Vorrichtung nach einem der Ansprüche 1 bis 11, **dadurch gekennzeichnet, dass** den Permanentmagnetmitteln ein den Permanentmagnetfluss leitender Konusabschnitt (44) zugeordnet ist, der sich entlang der Expansionsrichtung erstreckt.

## Claims

1. An actuator device with an expansion unit (10) having a magnetically active shape memory alloy material (12), which from an starting position executes an expansion movement along a direction of expansion as a reaction to an application of current to a coil device (30),
and interacts with restoring means, which exert a restoring force, opposed to the direction of expansion, onto the expansion unit (10),
**characterised in that**
the restoring means have permanent magnetic means, which engage with, or are located on, a section of the expansion unit (10), such that the permanent magnetically generated restoring force alters with an increasing expansion stroke in the direction of expansion, wherein
the permanent magnetic means (16, 34, 40, 52, 54) are formed and/or equipped such that with no application of current to the coil device (30) a contraction of the expansion unit (10) can take place along the expansion stroke into the starting position.

2. The device according to claim 1, **characterised in that** the permanent magnetic means are formed and/or equipped such that the permanent magnetically generated restoring force lowers or reduces with an increasing expansion stroke in at least some sections.

3. The device according to claim 1 or 2, **characterised in that** the shape memory alloy material (12), designed so as to be extended along the direction of expansion, laterally, and/or on the sleeve, has associated flux-conducting means (18, 32), which effect a magnetic penetration (20) of the shape memory alloy material (12) as a result of the energisation in a direction of flux transverse to the direction of expansion.

4. The device according to claim 3, **characterised in that** the flux-conducting means interact with the permanent magnetic means, such that a permanent magnetic flux of the permanent magnetic means flows through at least some sections of the flux-conducting means during the energisation, and with no application of current to the coil device (30).

5. The device according to any one of the claims 1 to 4, **characterised in that** the expansion unit (10), of extended form, has the permanent magnetic means (16, 34, 40) on an end section moved by the expansion.

6. The device according to any one of the claims 1 to 5, **characterised in that** permanent magnetic flux-conducting means (24, 36) are associated with the permanent magnetic means; these can conduct a permanent magnetic flux to a stationary core unit (18) associated with the shape memory alloy material (12).

7. The device according to claim 6, **characterised in that** the permanent magnetic flux-conducting means, or the permanent magnetic means, are shaped in the form of a cup, arc or yoke.

8. The device according to any one of the claims 1 to 7, **characterised in that** the permanent magnetic means, with respect to the direction of expansion, have an axially magnetised permanent magnet body.

9. The device according to any one of the claims 1 to 8, **characterised in that** the permanent magnetic means have a permanent magnetic body that is shaped in the form of a disk and is radially magnetised.

10. The device according to any one of the claims 1 to 9, **characterised in that** a first permanent magnetic body of the permanent magnetic means is provided, preferably at the end of the expansion unit (10) and for purposes of magnetic interaction with a second permanent magnetic body of the permanent magnetic means, which is preferably provided on a stator section (18), laterally adjacent to the first permanent magnetic body.

11. The device according to claim 10, **characterised in that** the first and second permanent magnetic bodies are implemented, with respect to the direction of expansion, as radially magnetised permanent magnetic bodies with similar poles directed towards one another.

12. The device according to any one of the claims 1 to 11, **characterised in that** a cone section (44) conducting the permanent magnetic flux, is associated with the permanent magnetic means; it extends along the direction of expansion.

## Revendications

1. Dispositif d'actionneur comprenant une unité d'expansion (10) présentant un matériau en alliage à mémoire de forme à action magnétique (12), laquelle, en réaction à l'alimentation en courant électrique d'un dispositif de bobine (30), effectue le long d'une direction d'expansion un mouvement d'expansion à partir d'une position de départ et coopère avec des moyens de rappel qui exercent sur l'unité d'expansion (10) une force de rappel opposée à la direction d'expansion,
**caractérisé en ce que**
les moyens de rappel présentent des moyens d'aimant permanent qui viennent en contact avec ou s'appliquent contre une portion de l'unité d'expansion (10) de telle sorte que la force de rappel produite par l'aimant permanent varie en fonction de l'augmentation de la course d'expansion dans la direction d'expansion,
les moyens d'aimant permanent (16, 34, 40, 52, 54) étant réalisés et/ou prévus de telle sorte qu'une contraction de l'unité d'expansion (10) dans la position de départ puisse avoir lieu lorsque le dispositif de bobine (30) n'est pas alimenté en courant électrique, le long de la course d'expansion.

2. Dispositif selon la revendication 1, **caractérisé en ce que** les moyens d'aimant permanent sont réalisés et/ou prévus de telle sorte que la force de rappel produite par l'aimant permanent diminue ou chute au moins en partie de manière correspondant à l'augmentation de la course d'expansion.

3. Dispositif selon la revendication 1 ou 2, **caractérisé en ce que** le matériau en alliage à mémoire de forme (12) réalisé sous forme allongée le long de la direction d'expansion présente latéralement et/ou du côté de l'enveloppe des moyens de guidage de flux (18, 32) associés, qui provoquent une force magnétomotrice (20) à travers le matériau en alliage à mémoire de forme (12) par alimentation en courant électrique dans une direction de flux transversalement à la direction d'expansion.

4. Dispositif selon la revendication 3, **caractérisé en ce que** les moyens de guidage de flux coopèrent avec les moyens d'aimant permanent de telle sorte que les moyens de guidage de flux, pendant l'alimentation en courant électrique et lorsque le dispositif de bobine (30) n'est pas alimenté en courant électrique, soient au moins en partie parcourus par un flux magnétique permanent des moyens d'aimant permanent.

5. Dispositif selon l'une quelconque des revendications 1 à 4, **caractérisé en ce que** l'unité d'expansion (10) réalisée sous forme allongée présente les moyens d'aimant permanent (16, 34, 40) au niveau d'une portion d'extrémité déplacée par l'expansion.

6. Dispositif selon l'une quelconque des revendications 1 à 5, **caractérisé en ce que** des moyens de guidage de flux magnétique permanent (24, 36) sont associés aux moyens d'aimant permanent, et peuvent conduire un flux magnétique permanent vers une unité de noyau (18) stationnaire associée au matériau en alliage à mémoire de forme (12).

7. Dispositif selon la revendication 6, **caractérisé en ce que** les moyens de guidage de flux magnétique permanent ou les moyens d'aimant permanent sont en forme de godet, de forme courbe ou en forme d'étrier.

8. Dispositif selon l'une quelconque des revendications 1 à 7, **caractérisé en ce que** les moyens d'aimant permanent, par rapport à la direction d'expansion, présentent un corps d'aimant permanent à aimantation axiale.

9. Dispositif selon l'une quelconque des revendications 1 à 8, **caractérisé en ce que** les moyens d'aimant permanent présentent un corps d'aimant permanent réalisé en forme de disque et à aimantation radiale.

10. Dispositif selon l'une quelconque des revendications 1 à 9, **caractérisé en ce qu'**il est prévu un premier corps d'aimant permanent des moyens d'aimant permanent de préférence du côté de l'extrémité au niveau de l'unité d'expansion (10), destiné à coopérer magnétiquement avec un deuxième corps d'aimant permanent des moyens d'aimant permanent, de préférence adjacent latéralement à celui-ci et prévu sur une portion de stator (18).

11. Dispositif selon la revendication 10, **caractérisé en ce que** le premier et le deuxième corps d'aimant permanent sont réalisés en tant que corps d'aimant permanent à aimantation radiale par rapport à la direction d'expansion, avec des pôles identiques orientés les uns vers les autres.

12. Dispositif selon l'une quelconque des revendications 1 à 11, **caractérisé en ce qu'**une portion de cône (44) conduisant le flux magnétique permanent, qui s'étend le long de la direction d'expansion, est associée aux moyens d'aimant permanent.
